# EUROPÄISCHE PATENTSCHRIFT

(11) **EP 2 942 129 B1**
(45) Veröffentlichungstag und Bekanntmachung des Hinweises auf die Patenterteilung: **05.07.2017**
(21) Anmeldenummer: 14167030.7
(22) Anmeldetag: 05.05.2014
(51) Int. Cl.: B22F 7/08, H01B 1/22, B22F 1/00, H01L 23/00

(54) **Metallpaste und deren Verwendung zum Verbinden von Bauelementen**
Metal paste and its use in joining components
Pâte métallique et son utilisation pour relier des éléments de construction

(43) Veröffentlichungstag der Anmeldung: 11.11.2015
(73) Patentinhaber: Heraeus Deutschland GmbH & Co. KG, 63450 Hanau (DE)
(72) Erfinder: Nachreiner, Jens, 36381 Schlüchtern (DE)
(74) Vertreter: Heraeus IP

(56) Entgegenhaltungen:
- EP-A1- 0 467 119
- WO-A1-2011/026623
- JP-A- 2013 229 284

## Beschreibung

Die vorliegende Erfindung betrifft eine Metallpaste und ein Verfahren zum Verbinden von Bauelementen, bei dem diese Metallpaste eingesetzt wird.

Im Bereich der Leistungs- und Konsumerelektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die eine nur unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar.

Herkömmliche Sinterverfahren benötigen jedoch entweder einen hohen Prozessdruck und/oder eine hohe Prozesstemperatur. Diese Bedingungen führen häufig zu Schädigungen der zu verbindenden Bauelemente, so dass herkömmliche Sinterverfahren für viele Anwendungen ausscheiden.

Der Einsatz von Metallpasten in einem Sinterprozess zum Verbinden von Bauelementen im Bereich der Leistungselektronik ist bekannt.

WO2011/026623 A1 offenbart eine Metallpaste enthaltend 75 bis 90 Gew.-% (Gewichtsprozent) wenigstens eines Metalls, das in Form von Partikeln vorliegt, die ein Coating aufweisen, das wenigstens eine organische Verbindung enthält, 0 bis 12 Gew.-% wenigstens eines Metallprecursors, 6 bis 20 Gew.-% wenigstens eines Lösemittels und 0,1 bis 15 Gew.-% wenigstens eines Sinterhilfsmittels, sowie die Verwendung der Metallpaste zur Verbindung von Bauelementen mittels eines Sinterverfahrens.

Aufgabe der Erfindung ist die Bereitstellung eines bei Temperaturen von beispielsweise 200 bis 250 °C auch drucklos durchführbaren Sinterverfahrens zur stabilen Verbindung von Bauelementen. Mit dem Verfahren sollen Kontaktstellen zwischen den zu verbindenden Bauelementen gebildet werden, die eine niedrige Porosität und eine hohe elektrische und thermische Leitfähigkeit aufweisen. Eine weitere Aufgabe der vorliegenden Erfindung besteht darin, eine zur Durchführung eines derartigen Sinterverfahrens angepasste Metallpaste bereitzustellen.

Die Erfindung betrifft ein Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallpaste aufweist, die sich zwischen Bauelement 1 und Bauelement 2 befindet, und (b) die Sandwichanordnung sintert, wobei die Metallpaste aus (A) 75 bis 90 Gew.-% wenigstens eines Metalls, das in Form von Partikeln vorliegt, die ein Coating aufweisen, das wenigstens eine organische Verbindung enthält, (B) 0 bis 12 Gew.-% wenigstens eines Metallprecursors, (C) 6 bis 20 Gew.-% eines Gemischs mindestens zweier organischer Lösemittel und (D) 0 bis 10 Gew.-% wenigstens eines Sinterhilfsmittels und (E) 0 bis 15 Gew.-% eines oder mehrerer weiterer Inhaltsstoffe ausgewählt unter Dispersionsmitteln, Tensiden, Entschäumern, Bindemitteln, Polymeren und/oder viskositätssteuernden Mitteln besteht, dadurch gekennzeichnet, dass das Lösemittelgemisch (C) zu 30 bis 60 Gew.-% aus mindestens einem mit Ausnahme einer Methylsubsitution am vorletzten C-Atom unsubstituierten 1-Hydroxyalkan mit 16-20 C-Atomen besteht.

Die Erfindung betrifft ferner eine Metallpaste, die aus (A) 75 bis 90 Gew.-% wenigstens eines Metalls, das in Form von Partikeln vorliegt, die ein Coating aufweisen, das wenigstens eine organische Verbindung enthält, (B) 0 bis 12 Gew.-% wenigstens eines Metallprecursors, (C) 6 bis 20 Gew.-% eines Gemischs mindestens zweier organischer Lösemittel und (D) 0 bis 10 Gew.-% wenigstens eines Sinterhilfsmittels und (E) 0 bis 15 Gew.-% eines oder mehrerer weiterer Inhaltsstoffe ausgewählt unter Dispersionsmitteln, Tensiden, Entschäumern, Bindemitteln, Polymeren und/oder viskositätssteuernden Mitteln besteht, dadurch gekennzeichnet, dass das Lösemittelgemisch (C) zu 30 bis 60 Gew.-% aus mindestens einem mit Ausnahme einer Methylsubsitution am vorletzten C-Atom unsubstituierten 1-Hydroxyalkan mit 16-20 C-Atomen besteht.

Die erfindungsgemäße Metallpaste enthält 75 bis 90 Gew.-%, vorzugsweise 77 bis 89 Gew.-%, mehr bevorzugt 78 bis 87 Gew.-% und noch mehr bevorzugt 78 bis 86 Gew.-% wenigstens eines Metalls, das in Form von Partikeln vorliegt, die ein Coating aufweisen, das wenigstens eine organische Verbindung enthält. Die hier gemachten Gewichtsangaben schließen das Gewicht der Coatingverbindungen auf den Partikeln mit ein.

Unter den Begriff Metall fallen sowohl reine Metalle als auch Metalllegierungen.

Im Rahmen der Erfindung bezieht sich der Begriff Metall auf Elemente, die im Periodensystem der Elemente in der selben Periode wie Bor, aber links von Bor, in der selben Periode wie Silizium, aber links von Silizium, in der selben Periode wie Germanium, aber links von Germanium, und in der selben Periode wie Antimon, aber links von Antimon stehen, sowie auf alle Elemente, die eine höhere Ordnungszahl als 55 aufweisen.

Als reine Metalle werden im Rahmen der Erfindung Metalle verstanden, die ein Metall mit einer Reinheit von wenigstens 95 Gew.-%, bevorzugt wenigstens 98 Gew.-%, mehr bevorzugt wenigstens 99 Gew.-% und noch mehr bevorzugt wenigstens 99,9 Gew.-% enthalten.

Gemäß einer bevorzugten Ausführungsform handelt es sich bei dem Metall um Kupfer, Silber, Gold, Nickel, Palladium, Platin oder Aluminium, insbesondere Silber.

Als Metalllegierungen werden metallische Gemische aus wenigstens zwei Komponenten verstanden, von denen wenigstens eine ein Metall ist.

Gemäß einer bevorzugten Ausführungsform wird als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gew.-%, vorzugsweise wenigstens 95 Gew.-%, mehr bevorzugt wenigstens 99 Gew.-% und noch mehr bevorzugt 100 Gew.-% beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

In der erfindungsgemäßen Metallpaste können als Metall ein reines Metall, mehrere Arten von reinen Metallen, eine Art von Metalllegierung, mehrere Arten von Metalllegierungen oder Mischungen davon enthalten sein.

Das Metall liegt in der Metallpaste in Form von Partikeln vor.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gew.-%, mehr bevorzugt wenigstens 80 Gew.-%, noch mehr bevorzugt wenigstens 90 Gew.-% oder 100 Gew.-% der Partikel in der Form von Flakes vorliegen.

Die Metallpartikel sind gecoatet.

Unter einem Coating von Partikeln wird eine festhaftende Schicht auf der Oberfläche von Partikeln verstanden.

Das Coating der Metallpartikel enthält wenigstens eine Art von Coatingverbindungen.

Bei diesen Coatingverbindungen handelt es sich um organische Verbindungen.

Bei den organischen Verbindungen, die als Coatingverbindungen dienen, handelt es sich um kohlenstoffhaltige Verbindungen, die eine Agglomeration der Metallpartikel verhindern.

Gemäß einer bevorzugten Ausführungsform tragen die Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen oder Nitrilgruppen in Betracht. Bevorzugte funktionelle Gruppen sind Carbonsäuregruppen und Carbonsäureestergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die Coatingverbindungen mit wenigstens einer funktionellen Gruppe weisen vorzugsweise 1 bis 50, mehr bevorzugt 2 bis 24, noch mehr bevorzugt 6 bis 24 und noch mehr bevorzugt 8 bis 20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 10 bis 24 und noch mehr bevorzugt 12 bis 18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Aluminiumstearat, Kupferstearat, Natriumstearat, Kaliumstearat, Natriumpalmitat und Kaliumpalmitat.

Die Coatingverbindungen können mittels herkömmlicher und aus dem Stand der Technik bekannter Verfahren auf die Oberfläche der Metallpartikel aufgetragen werden.

Beispielsweise ist es möglich, die Coatingverbindungen, insbesondere die vorstehend erwähnten Stearate oder Palmitate, in Lösemitteln aufzuschlämmen und die aufgeschlämmten Coatingverbindungen in Kugelmühlen mit den Metallpartikeln zu vermahlen. Nach dem Mahlen werden die mit den Coatingverbindungen beschichteten Metallpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, die vorzugsweise 8 bis 24, mehr bevorzugt 10 bis 24 und noch mehr bevorzugt 12 bis 18 Kohlenstoffatome aufweisen, an dem gesamten Coating wenigstens 60 Gew.-%, mehr bevorzugt wenigstens 70 Gew.-%, noch mehr bevorzugt wenigstens 80 Gew.-%, noch mehr bevorzugt wenigstens 90 Gew.-%, insbesondere wenigstens 95 Gew.-%, wenigstens 99 Gew.-% oder 100 Gew.-%.

Üblicherweise beträgt der Anteil der Coatingverbindungen, vorzugsweise der Coatingverbindungen, die aus der Gruppe ausgewählt sind, die aus freien Fettsäuren, Fettsäuresalzen und Fettsäureestern mit 8 bis 24, mehr bevorzugt 10 bis 24 und noch mehr bevorzugt 12 bis 18 Kohlenstoffatomen besteht, 0,01 bis 2 Gew.-%, vorzugsweise 0,3 bis 1,5 Gew.-%, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 bis 0,03 g, mehr bevorzugt 0,0001 bis 0,02 g an Coatingverbindungen pro Quadratmeter (m²) Oberfläche der Metallpartikel.

Die erfindungsgemäße Metallpaste enthält 0 bis 12 Gew.-%, vorzugsweise 0,1 bis 12 Gew.-%, mehr bevorzugt 1 bis 10 Gew.-% und noch mehr bevorzugt 2 bis 8 Gew.-% wenigstens eines Metallprecursors.

Unter Metallprecursor wird im Rahmen der Erfindung eine Verbindung verstanden, die wenigstens ein Metall enthält. Vorzugsweise handelt es sich dabei um eine Verbindung, die sich bei Temperaturen von unter 200°C unter Freisetzung eines Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor handelt. So kann beispielsweise eine Paste, die eine zu testende Verbindung enthält, auf ein Substrat mit einer Silberoberfläche abgeschieden, auf 200°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor.

Gemäß einer bevorzugten Ausführungsform handelt es sich bei dem Metallprecursor um einen endotherm zersetzbaren Metallprecursor. Unter endotherm zersetzbarem Metallprecursor soll ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Gemäß einer weiteren bevorzugten Ausführungsform weist der Metallprecursor ein Metall auf, das auch im partikelförmigen Metall (A) enthalten ist.

Vorzugsweise umfasst der Metallprecursor als Metall wenigstens ein Element, das aus der Gruppe ausgewählt ist, die aus Kupfer, Silber, Gold, Nickel, Palladium und Platin besteht.

Es kann bevorzugt sein, als Metallprecursor endotherm zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silber(I)lactat, Silber(II)-formiat, Silbercitrat, Silberoxid (zum Beispiel AgO oder Ag₂O), Kupfer(II)-lactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird als Metallprecursor Silbercarbonat, Silber(I)-oxid oder Silber(II)-oxid verwendet.

Falls vorhanden, liegt der Metallprecursor in der Metallpaste vorzugsweise in der Form von Partikeln vor.

Die Metallprecursor-Partikel können die Form von Flakes oder eine sphärische (kugelige) Form aufweisen. Vorzugsweise liegen die Partikel des Metallprecursors als Flakes vor.

Die erfindungsgemäße Metallpaste enthält 6 bis 20 Gew.-%, vorzugsweise 7 bis 18 Gew.-%, mehr bevorzugt 8 bis 17 Gew.-% und noch mehr bevorzugt 10 bis 15 Gew.-% eines Gemischs mindestens zweier organischer Lösemittel, welches zu 30 bis 60 Gew.-%, bevorzugt 30 bis 50 Gew.-%, aus mindestens einem mit Ausnahme einer Methylsubsitution am vorletzten C-Atom unsubstituierten 1-Hydroxyalkan mit 16-20 C-Atomen besteht.

Bei mit Ausnahme einer Methylsubsitution am vorletzten C-Atom unsubstituierten 1-Hydroxyalkanen mit 16-20 C-Atomen handelt es sich um die Verbindungen: 14-Methylpentadecan-1-ol, 15-Methylhexadecan-1-ol, 16-Methylheptadecan-1-ol, 17-Methyloctadecan-1-ol und 18-Methylnonadecan-1-ol. Bevorzugt ist das 16-Methylheptadecan-1-ol, im Handel auch unter der Bezeichnung Isooctadecanol erhältlich.

Bevorzugt enthält das Gemisch der mindestens zwei organischen Lösemittel nur 16-Methylheptadecan-1-ol als mit Ausnahme einer Methylsubsitution am vorletzten C-Atom unsubstituiertes 1-Hydroxyalkan mit 16-20 C-Atomen.

Neben den 30 bis 60 Gew.-%, bevorzugt 30 bis 50 Gew.-%, mindestens eines mit Ausnahme einer Methylsubsitution am vorletzten C-Atom unsubstituierten 1-Hydroxyalkans mit 16-20 C-Atomen enthält das Gemisch der mindestens zwei organischen Lösemittel entsprechend 70 bis 40 Gew.-%, bevorzugt 70 bis 50 Gew.-%, (d.h. den zur Ergänzung auf 100 Gew.-% fehlenden Mengenanteil) mindestens eines weiteren organischen Lösemittels, d.h. mindestens eines von mit Ausnahme einer Methylsubsitution am vorletzten C-Atom unsubstituierten 1-Hydroxyalkans mit 16-20 C-Atomen verschiedenen organischen Lösemittels. Dabei handelt es sich um für Metallpasten üblicherweise verwendete organische Lösemittel. Beispiele sind Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, dibasische Ester (vorzugsweise Dimethylester der Glutar-, Adipin- oder Bernsteinsäure oder Mischungen davon), Glycerin, Diethylenglykol, Triethylenglykol und aliphatische, insbesondere gesättigte aliphatische Kohlenwasserstoffe mit 5 bis 32 C-Atomen, mehr bevorzugt 10 bis 25 C-Atomen und noch mehr bevorzugt 16 bis 20 C-Atomen. Solche aliphatischen Kohlenwassertoffe werden beispielsweise von Exxon Mobil unter der Marke Exxsol™ D140 oder unter der Marke Isopar M™ vertrieben.

Bevorzugt besteht das Gemisch der mindestens zwei organischen Lösemittel aus 30 bis 60 Gew.-%, bevorzugt 30 bis 50 Gew.-%, 16-Methylheptadecan-1-ol und 70 bis 40 Gew.-%, bevorzugt 70 bis 50 Gew.-%, mindestens eines organischen Lösemittels ausgewählt aus 1-Tridecanol, Terpineolen und gesättigten aliphatischen Kohlenwasserstoffen mit 16 bis 20 C-Atomen, wobei sich die Gew.-% zu 100 Gew.-% addieren.

In einer besonderen Ausführungsform unterscheiden sich das mindestens eine in der erfindungsgemäßen Metallpaste enthaltene, mit Ausnahme einer Methylsubsitution am vorletzten C-Atom unsubstituierte 1-Hydroxy-C16-C20-alkan und die ebenfalls in der erfindungsgemäßen Metallpaste enthaltene, im Zusammenhang mit der Metallkomponente (A) erläuterte wenigstens eine Coatingverbindung um nicht mehr als zwei, bevorzugt um nicht mehr als ein, besonders bevorzugt nicht in der Anzahl ihrer C-Atome. Mit anderen Worten, enthält die erfindungsgemäße Metallpaste freie Fettsäuren, Fettsäuresalze oder Fettsäureester als ein oder mehrere solcher Coatingverbindungen der Metallpartikel der Komponente (A), dann unterscheiden sich das oder die in der erfindungsgemäßen Metallpaste enthaltenen, mit Ausnahme einer Methylsubsitution am vorletzten C-Atom unsubstituierten 1-Hydroxy-C16-C20-alkane und besagte Fettsäure(n), Fettsäuresalz(e) oder Fettsäureester um nicht mehr als zwei, bevorzugt um nicht mehr als ein, besonders bevorzugt nicht in der Anzahl ihrer C-Atome.

Die erfindungsgemäße Metallpaste enthält 0 bis 10 Gew.-%, vorzugsweise 0 bis 8 Gew.-% wenigstens eines Sinterhilfsmittels. Beispiele für Sinterhilfsmittel sind organische Peroxide, anorganische Peroxide und anorganische Säuren, wie beispielsweise in WO2011/026623 A1 beschrieben.

Die erfindungsgemäße Metallpaste enthält neben den vorstehend erläuterten Bestandteilen (A) bis (D) 0 bis 15 Gew.-%, vorzugsweise 0 bis 12 Gew.-%, mehr bevorzugt 0,1 bis 10 Gew.-% Gew.-% eines oder mehrerer weiterer Inhaltsstoffe (E). Bei diesen weiteren Inhaltsstoffen handelt es sich vorzugsweise um üblicherweise in Metallpasten eingesetzte Inhaltsstoffe ausgewählt unter Dispersionsmitteln, Tensiden, Entschäumern, Bindemitteln, Polymeren wie Cellulosederivaten, beispielsweise Methylcellulose, Ethylcellulose, Ethylmethylcellulose, Carboxycellulose, Hydroxypropylcellulose, Hydroxyethylcellulose, Hydroxymethylcellulose, und/oder viskositätssteuernde Mitteln.

Die Summe der Gew.-% der Bestandteile (A) bis (E) beträgt 100 Gew.-%, bezogen auf die erfindungsgemäße Metallpaste, d.h. vor ihrer Applikation. Dementsprechend kann die Herstellung der erfindungsgemäßen Metallpaste durch Vermischen der Bestandteile (A) bis (E) erfolgen. Dabei können übliche dem Fachmann bekannte Vorrichtungen verwendet werden, beispielsweise Rührwerke und Dreiwalzwerke.

Die erfindungsgemäße Metallpaste kann als Sinterpaste, d.h. in einem Sinterverfahren eingesetzt werden. Unter Sintern wird das Verbinden von zwei oder mehr Bauelementen durch Erhitzen unter Vermeidung dessen, dass die Metallpartikel die flüssige Phase erreichen, verstanden. Das unter Verwendung der erfindungsgemäßen Metallpaste durchgeführte Sinterverfahren kann unter Druckanwendung oder, was einen Vorteil der vorliegenden Erfindung darstellt, drucklos durchgeführt werden. Drucklose Durchführbarkeit des Sinterverfahrens bedeutet, dass trotz Verzichts auf die Anwendung von Druck eine hinreichend feste Verbindung zwischen Bauelementen erzielt wird. Die Möglichkeit, den Sinterprozess drucklos durchzuführen, erlaubt es, druckempfindliche, beispielsweise zerbrechliche oder in ihrem Gefüge mechanisch empfindliche Bauelemente im Sinterverfahren einzusetzen. In ihrem Gefüge mechanisch empfindliche Elektronikbauelemente erleiden bei unzulässiger Druckbelastung elektrische Fehlfunktionen.

Unter dem Verbinden von wenigstens zwei Bauelementen wird das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden wird, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise Aluminium-Kühlkörper oder Kupfer-Kühlkörper) oder andere passive Bauelemente (zum Beispiel Widerstände, Kondensatoren oder Spulen) handeln.

Die zu verbindenden Bauelementen können gleichartige oder verschiedenartige Bauelemente sein.

Unter bevorzugten Ausführungsformen betrifft die Erfindung die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat. Dabei kann die Verbindung beispielsweise zwischen Kupfer- oder Silberkontaktflächen der Elektronikbauelemente mit Kupfer- oder Silberkontaktflächen der Substrate erfolgen, d.h. es kann zur Ausbildung beispielsweise einer Kupfer-Silber-, Kupfer-Kupfer-, Silber-Kupfer- oder Silber-Silber-Verbindung kommen.

Wie im vorhergehenden Absatz schon beschrieben, können die Bauelemente wenigstens eine Metallisierungsschicht umfassen. Diese Metallisierungsschicht ist vorzugsweise Teil des Bauelements. Die Metallisierungsschicht befindet sich vorzugsweise an wenigstens einer Oberfläche des Bauelements.

Bevorzugt wird die Verbindung der Bauelemente mittels der erfindungsgemäßen Metallpaste über besagte Metallisierungsschicht bzw. -schichten vorgenommen.

Die Metallisierungsschicht kann reines Metall aufweisen. So kann es bevorzugt sein, wenn die Metallisierungsschicht wenigstens 50 Gew.-%, mehr bevorzugt wenigstens 70 Gew.-%, noch mehr bevorzugt wenigstens 90 Gew.-% oder aber 100 Gew.-% an reinem Metall aufweist. Das reine Metall ist vorzugsweise aus der Gruppe ausgewählt, die aus Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Silber, Kupfer, Gold, Nickel, Palladium und Platin besteht. Es kann auch bevorzugt sein, dass wenigstens zwei Metalle, die aus der Gruppe ausgewählt sind, die aus Silber, Kupfer, Gold, Nickel, Palladium und Platin besteht, in der Legierung der Metallisierungsschicht enthalten sind.

Die Metallisierungsschicht kann auch einen mehrlagigen Aufbau aufweisen. So kann es beispielsweise bevorzugt sein, wenn wenigstens eine Oberfläche der zu verbindenden Bauelemente eine Metallisierungsschicht aus mehreren Lagen umfasst, die die vorstehend genannten reinen Metalle und/oder Legierungen aufweisen.

Im erfindungsgemäßen Verfahren werden wenigstens zwei Bauelemente durch Sintern miteinander verbunden.

Dazu werden zunächst die zwei oder mehr Bauelemente miteinander in Kontakt gebracht. Das Kontaktieren erfolgt dabei über die erfindungsgemäße Metallpaste. Zu diesem Zweck wird eine Anordnung bereitgestellt, bei der sich zwischen jeweils zwei der wenigstens zwei Bauelemente erfindungsgemäße Metallpaste befindet.

Sollen daher zwei Bauelemente, Bauelement 1 und Bauelement 2, miteinander verbunden werden, so befindet sich die erfindungsgemäße Metallpaste vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallpaste sowohl zwischen Bauelement 1 und Bauelement 2 als auch zwischen Bauelement 2 und Bauelement 3.

Die einzelnen Bauelemente liegen in einer Sandwichanordnung vor und werden miteinander verbunden. Unter Sandwichanordnung ist eine Anordnung zu verstehen, bei der sich zwei Bauelemente übereinander befinden und die Bauelemente im Wesentlichen parallel zueinander angeordnet sind.

Die Anordnung aus wenigstens zwei Bauelementen und erfindungsgemäßer Metallpaste, wobei sich die Metallpaste zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallpaste versehen. Anschließend wird ein anderes Bauelement 2 mit einer seiner Oberflächen auf die Metallpaste, die auf die Oberfläche des Bauelements 1 aufgetragen worden ist, aufgesetzt.

Die Auftragung der erfindungsgemäßen Metallpaste auf die Oberfläche eines Bauelements kann mittels herkömmlicher Verfahren erfolgen, beispielsweise mittels Druckverfahren wie Siebdruck oder Schablonendruck. Andererseits kann die Auftragung der erfindungsgemäßen Metallpaste auch mittels Dispenstechnik, mittels Pintransfer oder durch Dippen erfolgen.

Im Anschluss an die Auftragung der erfindungsgemäßen Metallpaste wird vorzugsweise die mit der Metallpaste versehene Oberfläche dieses Bauelements mit einer Oberfläche des damit zu verbindenden Bauelements über die Metallpaste in Kontakt gebracht. Somit befindet sich zwischen den zu verbindenden Bauelementen eine Schicht erfindungsgemäße Metallpaste.

Die Nassschichtdicke zwischen den zu verbindenden Bauelementen liegt vorzugsweise im Bereich von 20 bis 100 µm. Unter Nassschichtdicke wird hier der Abstand zwischen den sich gegenüberliegenden Oberflächen der zu verbindenden Bauelemente vor einem gegebenenfalls stattfindenden Trocknen und vor dem Sintern verstanden. Die bevorzugte Nassschichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 20 bis 50 µm bevorzugt sein. Erfolgt die Auftragung der Metallpaste mittels Schablonendruck, dann kann die bevorzugte Nassschichtdicke im Bereich von 20 bis 100 µm liegen. Bei der Dispenstechnik kann die bevorzugte Nassschichtdicke im Bereich von 20 bis 100 µm liegen.

Optional wird vor dem Sintern ein Trocknungsschritt durchgeführt, d.h. eine Entfernung von organischem Lösemittel aus der applizierten Metallpaste. Gemäß einer bevorzugten Ausführungsform liegt der Anteil an organischem Lösemittels in der Metallpaste nach der Trocknung beispielsweise bei 0 bis 5 Gew.-%, bezogen auf den ursprünglichen Anteil an organischem Lösemittel in der erfindungsgemäßen Metallpaste, d.h. applikationsbereiten Metallpaste. Mit anderen Worten, gemäß dieser bevorzugten Ausführungsform werden beispielsweise 95 bis 100 Gew.-% der ursprünglich in der erfindungsgemäßen Metallpaste enthaltenen organischen Lösemittel bei der Trocknung entfernt.

Findet ein Trocknen statt, so kann die Trocknung im Falle des drucklosen Sinterns nach der Herstellung der Anordnung, also nach der Kontaktierung der zu verbindenden Bauelemente erfolgen. Im Falle des Drucksinterns kann die Trocknung auch nach dem Auftragen der Metallpaste auf die wenigstens eine Oberfläche des Bauelements und vor der Kontaktierung mit dem zu verbindenden Bauelement erfolgen.

Die Trocknungstemperatur liegt vorzugsweise im Bereich von 100 bis 150 °C.

Es versteht sich, dass die Trocknungszeit abhängig ist von der Zusammensetzung der erfindungsgemäßen Metallpaste und der Größe der Verbindungsfläche der zu sinternden Anordnung. Übliche Trocknungszeiten liegen im Bereich von 5 bis 45 Minuten.

Die Anordnung aus den wenigstens zwei Bauelementen und zwischen den Bauelementen befindlicher Metallpaste wird schließlich einem Sinterprozess unterworfen.

Das eigentliche Sintern erfolgt bei einer Temperatur von beispielsweise 200 bis 250 °C.

Beim Drucksintern liegt der Prozessdruck vorzugsweise unter 30 MPa und mehr bevorzugt unter 5 MPa. Beispielsweise liegt der Prozessdruck im Bereich von 1 bis 30 MPa und mehr bevorzugt im Bereich von 1 bis 5 MPa. Wie schon gesagt, liegt der besondere Vorteil der vorliegenden Erfindung darin, dass mit der erfindungsgemäßen Metallpaste die Durchführung des Sinterprozesses auch drucklos möglich ist und dabei dennoch eine hinreichend feste Verbindung von Bauelementen gelingt. Das drucklose Sintern empfiehlt sich, wenn mindestens eines der Bauelemente druckempfindlich, beispielsweise zerbrechlich oder in seinem Gefüge mechanisch empfindlich ist.

Die Sinterzeit liegt beispielsweise im Bereich von 2 bis 60 Minuten, beim Drucksintern beispielsweise im Bereich von 2 bis 5 Minuten, beim Drucklossintern beispielsweise im Bereich von 30 bis 60 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre durchzuführen. Unter sauerstofffreier Atmosphäre ist im Rahmen der Erfindung eine Atmosphäre zu verstehen, deren Sauerstoffgehalt nicht mehr als 10 ppm, vorzugsweise nicht mehr als 1 ppm und noch mehr bevorzugt nicht mehr als 0,1 ppm beträgt.

Das Sintern wird in einer herkömmlichen, zum Sintern geeigneten Vorrichtung durchgeführt, in der sich die vorstehend beschriebenen Prozessparameter einstellen lassen.

Die Erfindung wird im Folgenden anhand von Beispielen erläutert, die jedoch nicht als einschränkend verstanden werden sollen.

### Beispiele:

### 1. Herstellung von Metallpasten:

Zunächst wurden die erfindungsgemäßen Metallpasten 1 bis 2 und die Vergleichspasten 3 bis 7 durch Vermischen der einzelnen Bestandteile gemäß nachfolgender Tabelle hergestellt. Alle Mengenangaben bedeuten Gew.-%.

| | Paste 1 | Paste 2 | Paste 3 | Paste 4 | Paste 5 | Paste 6 | Paste 7 |
|---|---|---|---|---|---|---|---|
| Silberpartikel ¹⁾ | 83 | | 83 | | | | |
| Silberpartikel ²⁾ | | 85 | | 85 | 84 | 84 | 84 |
| Silbercarbonat | 4,9 | 4,9 | 4,9 | 4,9 | 4,9 | 4,9 | 4,9 |
| 16-Methylheptadecan-1-ol | 5 | 5 | | | | | |
| n-Heptadecanol | | | | | 5 | | |
| n-Octadecanol | | | | | | 5 | |
| n-Eicosanol | | | | | | | 5 |
| Tridecanol | 7,1 | 5,1 | 5,6 | 7,4 | 6,1 | 6,1 | 6,1 |
| Exxsol™ D140 | | | 6,5 | 2,7 | | | |
| | | | | | | | |
| Summe | 100 | 100 | 100 | 100 | 100 | 100 | 100 |

| | | | | | | | |
|---|---|---|---|---|---|---|---|
| ¹⁾ Silberflakes mit einem mittleren Teilchendurchmesser (d50) von 3 µm und einem Coating von 1,5 Gew.-% Stearinsäure ²⁾ Silberflakes mit einem mittleren Teilchendurchmesser (d50) von 3 µm und einem Coating von 1,5 Gew.-% Laurinsäure | | | | | | | |

### 2. Applikation und druckloses Sintern der Metallpasten:

Die jeweilige Metallpaste wurde mittels Dispensen auf die Oberfläche eines Silber-Leadframes in einer Nassschichtdicke von 50 µm appliziert. Anschließend wurde die applizierte Metallpaste ohne vorherige Trocknung mit einem Siliziumchip mit Silberkontaktfläche (4 · 6 mm²) in Kontakt gebracht. Das anschließende drucklose Sintern erfolgte nach folgendem Aufwärmprofil: Innerhalb von 60 Minuten wurde die Kontaktstelle kontinuierlich auf 160 °C erwärmt und für 30 Minuten bei 160 °C gehalten. Anschließend wurde die Temperatur innerhalb von 5 Minuten kontinuierlich auf 230 °C erhöht und 60 Minuten gehalten. Dann wurde innerhalb von 50 Minuten kontinuierlich auf 30 °C abgekühlt.

Nach dem Sintern wurde die Haftung über die Scherfestigkeit bestimmt. Dabei wurden die Bauelemente mit einem Schermeißel bei einer Geschwindigkeit von 0,3 mm/s bei 20 °C abgeschert. Die Kraft wurde mittels einer Kraftmessdose aufgenommen (Gerät DAGE 2000 der Firma DA-GE, Deutschland).

Tabelle 2 zeigt die mit den Metallpasten 1 bis 7 erhaltenen Ergebnisse.

**Tabelle 2:**

| Paste | 1 | 2 | 3 | 4 | 5 | 6 | 7 |
|---|---|---|---|---|---|---|---|
| Scherfestigkeit (N/mm²) | 8,4 | 6,8 | 7,3 | 4,9 | 5,2 | 5,9 | 5,6 |

## Patentansprüche

1. Metallpaste bestehend aus (A) 75 bis 90 Gew.-% wenigstens eines Metalls, das in Form von Partikeln vorliegt, die ein Coating aufweisen, das wenigstens eine organische Verbindung enthält, (B) 0 bis 12 Gew.-% wenigstens eines Metallprecursors, (C) 6 bis 20 Gew.-% eines Gemischs mindestens zweier organischer Lösemittel, (D) 0 bis 10 Gew.-% wenigstens eines Sinterhilfsmittels und (E) 0 bis 15 Gew.-% eines oder mehrerer weiterer Inhaltsstoffe ausgewählt unter Dispersionsmitteln, Tensiden, Entschäumern, Bindemitteln, Polymeren und/oder viskositätssteuernden Mitteln, **dadurch gekennzeichnet, dass** das Lösemittelgemisch (C) zu 30 bis 60 Gew.-% aus mindestens einem mit Ausnahme einer Methylsubsitution am vorletzten C-Atom unsubstituierten 1-Hydroxyalkan mit 16-20 C-Atomen besteht.

2. Metallpaste nach Anspruch 1, wobei das wenigstens eine Metall ausgewählt ist aus der aus Kupfer, Silber, Gold, Nickel, Palladium, Platin und Aluminium bestehenden Gruppe.

3. Metallpaste nach Anspruch 1 oder 2, wobei die Metallpartikel die Form von Flakes aufweisen.

4. Metallpaste nach Anspruch 1, 2 oder 3, wobei die wenigstens eine organische Verbindung ausgewählt ist aus der aus freien Fettsäuren, Fettsäuresalzen und Fettsäureestern bestehenden Gruppe.

5. Metallpaste nach einem der vorhergehenden Ansprüche, wobei sich das mindestens eine mit Ausnahme einer Methylsubsitution am vorletzten C-Atom unsubstituierte 1-Hydroxy-C16-C20-alkan und die wenigstens eine organische Verbindung in der Anzahl ihrer C-Atome um nicht mehr als zwei C-Atome unterscheiden.

6. Metallpaste nach einem der vorhergehenden Ansprüche, wobei das mindestens eine mit Ausnahme einer Methylsubsitution am vorletzten C-Atom unsubstituierte 1-Hydroxyalkan 16-Methylheptadecan-1-ol umfasst.

7. Metallpaste nach Anspruch 6, wobei das mindestens eine mit Ausnahme einer Methylsubsitution am vorletzten C-Atom unsubstituierte 1-Hydroxyalkan 16-Methylheptadecan-1-ol ist.

8. Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallpaste nach einem der vorhergehenden Ansprüche aufweist, die sich zwischen Bauelement 1 und Bauelement 2 befindet, und (b) die Sandwichanordnung sintert.

9. Verfahren nach Anspruch 8, wobei man unter Druckanwendung oder drucklos sintert.

10. Verfahren nach Anspruch 8 oder 9, wobei es sich bei den Bauelementen um in der Elektronik verwendete Teile handelt.

## Claims

1. A metal paste consisting of (A) 75 to 90 % by weight of at least one metal that is present in the form of particles comprising a coating that contains at least one organic compound, (B) 0 to 12 % by weight of at least one metal precursor, (C) 6 to 20 % by weight of a mixture of at least two organic solvents, (D) 0 to 10 % by weight of at least one sintering aid, and (E) 0 to 15 % by weight of one or more further ingredients select from dispersion agents, surfactants, de-foaming agents, binding agents, polymers and/or viscosity-controlling agents, **characterised in that** 30 to 60 % by weight of solvent mixture (C) consist of at least one 1-hydroxyalkane with 16-20 C-atoms that is non-substituted except for a methyl substitution on the penultimate C-atom.

2. Metal paste according to claim 1, whereby the at least one metal is selected from the group consisting of copper, silver, gold, nickel, palladium, platinum, and aluminium.

3. Metal paste according to claim 1 or 2, whereby the metal particles take the shape of flakes.

4. Metal paste according to claim 1, 2 or 3, whereby the at least one organic compound is selected from the group consisting of free fatty acids, fatty acid salts, and fatty acid esters.

5. Metal paste according to any one of the preceding claims, whereby the at least one 1-hydroxy-C16-C20-alkane that is non-substituted except for a methyl substitution on the penultimate C-atom and the at least one organic compound differ in the number of their C-atoms by not more than two C-atoms.

6. Metal paste according to any one of the preceding claims, whereby the at least one 1-hydroxyalkane that is non-substituted except for a methyl substitution on the penultimate C-atom comprises 16-methylheptadecan-1-ol.

7. Metal paste according to claim 6, whereby the at least one 1-hydroxyalkane that is non-substituted except for a methyl substitution on the penultimate C-atom is 16-methylheptadecan-1-ol.

8. Method for the connecting of components, consisting of (a) providing a sandwich arrangement that comprises at least (a1) one component 1, (a2) one component 2, and (a3) a metal paste according to any one of the preceding claims that is situated between component 1 and component 2, and (b) sintering the sandwich arrangement.

9. Method according to claim 8, whereby the sintering takes place with or without pressure.

10. Method according to claim 8 or 9, whereby the components are parts that are used in electronics.

## Revendications

1. Pâte métallique constituée de (A) 75 à 90 % en poids d'au moins un métal qui est présent sous la forme de particules qui présentent un enrobage qui contient au moins un composé organique, (B) 0 à 12 % en poids d'au moins un précurseur métallique, (C) 6 à 20 % en poids d'un mélange d'au moins deux solvants organiques, (D) 0 à 10 % en poids d'au moins un adjuvant de frittage et (E) 0 à 15 % en poids d'un ou plusieurs autres constituants sélectionnés parmi des dispersants, tensioactifs, agents antimoussants, liants, polymères et/ou agents de contrôle de la viscosité, **caractérisée en ce que** le mélange de solvants (C) se compose à 30 à 60 % en poids d'au moins un 1-hydroxyalcane avec 16 à 20 atomes de C non substitué à l'exception d'une substitution de méthyle sur l'avant-dernier atome de C.

2. Pâte métallique selon la revendication 1, dans laquelle l'au moins un métal est sélectionné parmi le groupe constitué du cuivre, argent, or, nickel, palladium, platine et aluminium.

3. Pâte métallique selon la revendication 1 ou 2, dans laquelle les particules métalliques présentent la forme de paillettes.

4. Pâte métallique selon la revendication 1, 2 ou 3, dans laquelle l'au moins un composé organique est sélectionné parmi le groupe constitué d'acides gras libres, de sels d'acide gras et d'esters d'acide gras.

5. Pâte métallique selon une des revendications précédentes, dans laquelle l'au moins un 1-hydroxy-C16-C20-alcane non substitué à l'exception d'une substitution de méthyle sur l'avant-dernier atome de C et l'au moins un composé organique se différencient au niveau du nombre de leurs atomes de C de pas plus de deux atomes de C.

6. Pâte métallique selon une des revendications précédentes, dans laquelle l'au moins un 1-hydroxyalcane non substitué à l'exception d'une substitution de méthyle sur l'avant-dernier atome de C comprend du 16-méthylheptadécan-1-ol.

7. Pâte métallique selon la revendication 6, dans laquelle l'au moins un 1-hydroxyalcane non substitué à l'exception d'une substitution de méthyle sur l'avant-dernier atome de C est le 16-méthylheptadécan-1-ol.

8. Procédé de connexion d'éléments de construction, lors duquel on (a) met à disposition un agencement en sandwich qui présente au moins (a1) un élément de construction 1, (a2) un élément de construction 2 et (a3) une pâte métallique selon une des revendications précédentes qui se trouve entre l'élément de construction 1 et l'élément de construction 2, et (b) fritte l'agencement en sandwich.

9. Procédé selon la revendication 8, dans lequel on fritte avec application de pression ou sans pression.

10. Procédé selon la revendication 8 ou 9, dans lequel il s'agit pour les éléments de construction de pièces utilisées en électronique.
